Europäisches Patentamt

European Patent Office

Office européen des brevets

(19)

(11) Veröffentlichungsnummer: **0 071 181**
**B1**

(12) **EUROPÄISCHE PATENTSCHRIFT**

(45) Veröffentlichungstag der Patentschrift:
03.06.87

(51) Int. Cl.⁴: **H 01 L 25/04**

(21) Anmeldenummer: **82106594.3**

(22) Anmeldetag: **21.07.82**

(54) Photovoltaisches Solarmodul.

(30) Priorität: 23.07.81 DE 3129167
23.10.81 DE 3142129

(43) Veröffentlichungstag der Anmeldung:
09.02.83 Patentblatt 83/6

(45) Bekanntmachung des Hinweises auf die Patenterteilung:
03.06.87 Patentblatt 87/23

(84) Benannte Vertragsstaaten:
CH DE FR GB IT LI

(56) Entgegenhaltungen:
FR - A - 2 286 509
FR - A - 2 382 772
GB - A - 1 522 618
GB - A - 2 025 691
US - A - 3 973 996
US - A - 4 104 083

EXTENDED ABSTRACTS OF THE JOURNAL OF THE
ELECTROCHEMICAL SOCIETY, Band 80-2, Oktober
1980, Seiten 720-725, Princeton, N.J., USA; B. BAUM et
al.: "Photovoltaic encapsulation materials"

(73) Patentinhaber: **Siemens Aktiengesellschaft Berlin und
München, Wittelsbacherplatz 2, D-8000 München 2 (DE)**

(72) Erfinder: **Lang, Franz Josef, Ing. grad.,
Kurt-Schumacher-Strasse 14, D-8400 Regensburg (DE)**
Erfinder: **Hollaus, Reinhard, Dipl.-Ing.,
Schillerstrasse 16, D-8407 Obertraubling (DE)**
Erfinder: **Reeh, Ulrike, Hollerstrasse 7a,
D-8000 München 50 (DE)**
Erfinder: **Denk, Hans, Dr. rer. nat., Hauserstrasse 38,
D-8035 Gauting (DE)**
Erfinder: **Habrich, Reiner, Reiherweg 14,
D-8016 Heimstetten (DE)**

# Beschreibung

Die Erfindung betrifft ein photovoltaisches Solarmodul (im folgenden kurz Solarmodul genannt), bei dem wenigstens eine Solarzelle in Kunststoff eingebettet ist und mechanisch fest mit einem Tragelement verbunden ist.

Ein solches Solarmodul ist aus US-A-4 104 083 bekannt.

Solarzellen müssen bekanntlich in Solarmodulen untergebracht werden, damit einerseits die einzelnen Solarzellen geschützt und andererseits grössere Flächen belegt werden können, ohne die Solarzellen einzeln verdrahten zu müssen.

Bisher gibt es verschiedene Varianten von auf der gesamten Fläche steifen Solarmodulen, die deshalb auch steife und ebene Rahmengerüste erfordern. Solche steifen Solarmodule können nicht an gekrümmte Flächen angepasst werden, was oft deren Anwendbarkeit stark herabsetzt.

Aus GB-A-1 522 618 ist ein Solarmodul bekannt in dem das Tragelement flexibel ausgebildet ist.

Eine Versteifung der Solarmodule ist aber unabdingbar, da ohne diese die einzelnen Solarzellen insbesondere durch Brechen zerstört werden.

Es ist daher Aufgabe der Erfindung, ein Solarmodul zu schaffen, das die Solarzellen vor Biegebeanspruchungen schützt, aber dennoch so flexibel ist, dass es auf gekrümmte Flächen aufgelegt werden kann.

Diese Aufgabe wird erfindungsgemäss durch die im kennzeichnenden Teil des Anspruchs 1 genannten Merkmale, gelöst.

An der Erfindung ist also wesentlich, dass nicht das gesamte Solarmodul als solches versteift ist. Vielmehr sind lediglich im wesentlichen nur die Bereiche versteift, die gegenüber Beschädigungen besonders gefährdet sind. Es werden also grundsätzlich nur die Bereiche bzw. Flächen mit den flächenförmigen, steifen Elementen ausgestattet, in denen die Solarzellen vorgesehen sind. Das flächenförmige, steife Element nimmt also etwa die gleiche Fläche wie die Solarzelle ein und füllt so zusammen mit der Solarzelle das Solarmodul partiell aus.

Da die Solarzellen durch steifes Material hinterfüttert sind, werden bei Zug-, Druck- oder Biegebeanspruchungen des flexiblen Tragelementes keine zerstörenden Kräfte auf die Solarzelle übertragen; andererseits kann das Solarmodul wegen des flexiblen Tragelementes an Krümmungen angepasst werden.

Durch diese partielle Versteifung im Solarzellenbereich kann die gesamte Solarmodulfläche wesentlich flexibler und «weicher» gestaltet werden. Damit sinken auch die Festigkeitsanforderungen an das insgesamt verwendete Material, wodurch das Solarmodul mit wesentlich verringertem Materialaufwand verwirklicht werden kann.

Ein weiterer Vorteil des erfindungsgemässen Solarmoduls besteht darin, dass ohne wesentliche Steigerung des spezifischen Flächengewichts praktisch beliebig grosse Modulflächen aufgebaut werden können.

Selbstverständlich können aber auch andere gefährdete Bereiche als die Solarzellen mit steifen Elementen verstärkt werden. Solche Bereiche sind beispielsweise die Verbindungsstellen zwischen einzelnen Solarzellen. In den Bereichen ausserhalb der versteifenden Elemente wird der Zusammenhalt des Solarmoduls durch das flexible Tragelement gewährleistet, das beispielsweise ein durch eine Lackschicht gegen Korrosion geschütztes, insbesondere verzinktes Metallgewebe oder -netz, z.B. ein Eisendrahtgewebe, ein Eisendrahtnetz oder ein flexibler Verbundwerkstoff, z.B. ein mit Glasfasern, Kohlefasern, Kunststofffasern etc. verstärktes Kunststoffgewebe oder Netz oder eine derartig verstärkte Folie sein kann.

Durch die Erfindung ist es möglich, mittels eines geringen Fertigungsaufwandes bei hoher Materialeinsparung solche Solarmodule herzustellen, mit denen auch gekrümmte Flächen belegt werden können, wie beispielsweise ein unebener Boden, Autodächer, Felswände, Hausfronten usw.

Mit grösser werdenden Solarmodulen sind bisher der flächenspezifische Materialeinsatz und der Fertigungsaufwand immer grösser geworden: Es werden beispielsweise immer dickere Gläser und immer kompliziertere Rahmen benötigt, um die erforderliche mechanische Festigkeit zu erzielen. Diese Abhängigkeit zwischen Fläche und Aufwand entfällt durch die Erfindung. Mit dem erfindungsgemässen Solarmodul können nämlich bei geringem Material- und Fertigungseinsatz grosse Flächen belegt werden. So sind beispielsweise weniger als ein Drittel an Material bzw. Gewicht gegenüber den bisherigen Modulen erforderlich.

Das Solarmodul kann aus vorgefertigten Folien, Bändern, kunstharzgetränkten Geweben usw. kontinuierlich gefertigt werden.

Im Prinzip werden bei der Erfindung flexible Materialien, gebildet aus Kunststofffolien oder flexiblen Verbundwerkstoffen, die verschiedene Aufgaben erfüllen, so um die partiell versteiften Solarzellen gelegt, dass daraus in einem Endlos-Herstellungsverfahren die gewünschten Solarmodule entstehen. Die Kunststofffolien können z.B. aus thermisch oder durch Ultraschall gegebenenfalls unter Druck verschweissbaren Kunststoffen oder aus Klebefolien oder Laminaten bestehen. Der Kunststoff kann ein duroplastischer Formstoff oder ein Epoxidharzformstoff oder ein Polyurethanharzformstoff oder ein Silikonharzformstoff oder ein Polyesterharzformstoff oder ein Acrylharzformstoff oder ein Thermoplast sein. Dabei kann der duroplastische Kunststoff im Giess-, Imprägnier-, Laminier- oder Beschichtungsverfahren erzeugt werden.

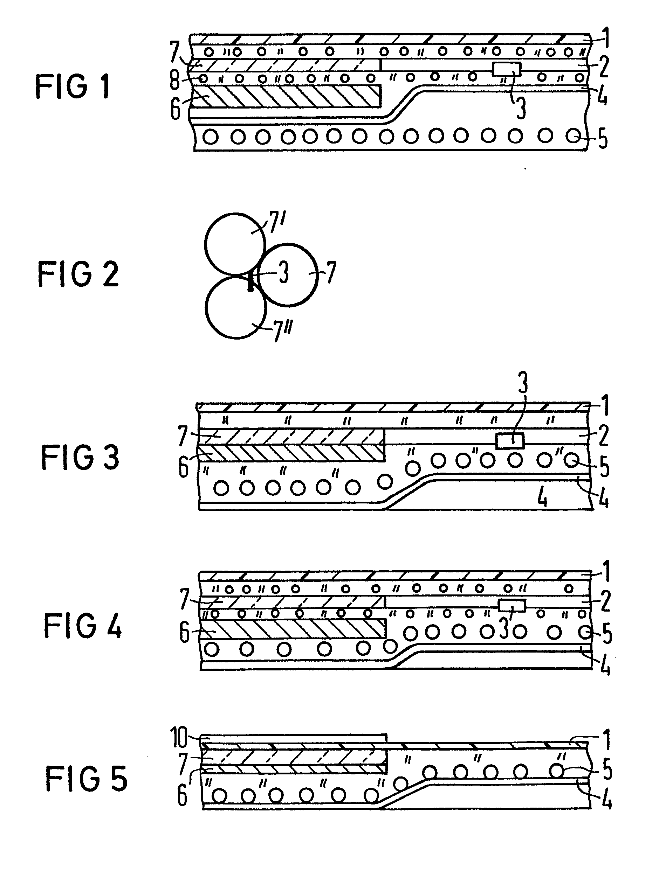

Nachfolgend wird die Erfindung an Hand der Zeichnung näher erläutert, in deren Fig. 1 bis 5 verschiedene Aufbauvarianten dargestellt sind, wobei Fig. 2 eine Draufsicht von Fig. 1 ist.

In Fig. 1 ist eine Solarzelle 7 in einen Kunststoff 2 eingebettet, der mit einem Glasgewebe 8 verstärkt ist. Das Glasgewebe 8 besteht hier aus zwei Lagen, von denen jeweils eine oberhalb und eine unterhalb der Solarzelle 7 vorgesehen ist.

Die Oberseite des Kunststoffs 2 ist mit einer Lichtdurchlässigen kratzfesten, witterungsbeständigen, reinigbaren Kunststoffschicht 1 (z.B. Tedlar = Polyvinylfluorid) abgedeckt. Zusätzlich ist in den Kunststoff 2 auch eine elektrische Zwischenverbindung 3 eingebettet, über die die einzelnen Solarzellen 7, die ein Solarmodul bilden, miteinander verbunden sind. Eine Mehrschichtfolie oder Verbundfolie 4 dient als Dampfdiffusionssperre. Unterhalb dieser Mehrschichtfolie 4 ist noch ein flexibles Tragelement 5 vorhanden.

Unterhalb der Solarzelle 7 befindet sich als flächenförmiges, steifes Element z.B. eine Metall- oder Kunststoffscheibe 6. Dieses steife Element 6 verstärkt das Solarmodul im Bereich der Solarzelle 7 und bildet so zusammen mit dem flexiblen Träger 5 einen zusammenhängenden Aufbau für das Modul. Der flexible Träger 5 ist mit der Mehrschichtfolie 4 verklebt und ragt im rechten Teil der Fig. 1 – also in den Bereichen ohne Solarzellen 7 – frei heraus. Auch die Metall- oder Kunststoffscheibe 6 kann mit dem Glasgewebe 8 verklebt werden.

Fig. 2 zeigt, wie einzelne Solarzellen 7, 7', 7'' und die Zwischenverbindung 3 zueinander angeordnet sind. In den Fig. 3 bis 5 sind einander entsprechende Bauteile mit den gleichen Bezugszeichen wie in Fig. 1 versehen.

Bei dem Ausführungsbeispiel der Fig. 3 ist kein Glasgewebe 8 erforderlich. Die Solarzelle 7 wird vor dem Einbau in den Kunststoff 2 auf die Platte 6 kaschiert. Der flexible Träger 5 ist bei diesem Ausführungsbeispiel in den Kunststoff 2 integriert.

Im Ausführungsbeispiel der Fig. 4 ist zusätzlich zum Ausführungsbeispiel der Fig. 3 ein Glasgewebe 8 in zwei Lagen eine oberhalb und eine unterhalb der Solarzelle 7 vorhanden.

Das Ausführungsbeispiel der Fig. 5 sieht zusätzlich eine Dünnglasschicht 10 vor, die als zusätzliche Versteifung wirkt, so dass die Platte 6 wesentlich dünner ausgeführt werden kann oder sogar ganz entbehrlich ist. Gegebenenfalls kann die Dünnglasschicht 10 auch in die Kunststoffschicht 1 integriert sein, so dass eine ebene Oberfläche entsteht.

**Patentansprüche**

1. Solarmodul, bei dem wenigstens eine Solarzelle (7) in Kunststoff (2) eingebettet ist und mechanisch fest mit einem Tragelement (5) verbunden ist, dadurch gekennzeichnet, dass das Tragelement (5) flexibel ausgebildet ist und dass jede Solarzelle (7) zum Schutz vor Beschädigung, insbesondere Brechen, dieser jeweiligen Solarzelle mit einem zusätzlichen flächenförmigen steifen Element (6) verstärkt ist, dass ebenfalls mechanisch fest mit der zugehörigen, in Kunststoff eingebetteten, Solarzelle verbunden ist.

2. Solarmodul nach Anspruch 1, dadurch gekennzeichnet, dass das flächenförmige, steife Element (6) etwa die gleiche Fläche wie die Solarzelle (7) einnimmt, also zusammen mit der Solarzelle das Solarmodul partiell ausfüllt.

3. Solarmodul nach Anspruch 1 und 2, dadurch gekennzeichnet, dass das flächenförmige, steife Element (6) mit dem die Solarzelle (7) umhüllenden Kunststoff (2) verbunden ist.

4. Solarmodul nach einem der Ansprüche 1 bis 3, dadurch gekennzeichnet, dass das Tragelement (5) ein verzinktes Eisendrahtgewebe oder verzinktes Eisendrahtnetz ist.

5. Solarmodul nach einem der Ansprüche 1 bis 3, dadurch gekennzeichnet, dass das Tragelement (5) aus Eisendrahtgewebe oder Netz mit einer Lackschicht überzogen ist.

6. Solarmodul nach einem der Ansprüche 1 bis 5, dadurch gekennzeichnet, dass zwischen dem Kunststoff (2) und dem Tragelement (5) eine als Dampfdiffusionssperre dienende Mehrschichtfolie (4) vorgesehen ist.

7. Solarmodul nach einem der Ansprüche 1 bis 6, dadurch gekennzeichnet, dass in den Kunststoff (2) ein Glasgewebe (8) eingebettet ist.

8. Solarmodul nach Anspruch 7, dadurch gekennzeichnet, dass das Glasgewebe (8) in jeweils einer Lage oberhalb und unterhalb der Solarzelle (7) verläuft.

9. Solarmodul nach einem der Ansprüche 1 bis 8, dadurch gekennzeichnet, dass die elektrische Verbindung (3) der Solarzellen in den Kunststoff (2) eingebettet ist.

10. Solarmodul nach einem der Ansprüche 1 bis 9, dadurch gekennzeichnet, dass eine lichtdurchlässige Kunststoffschicht (1) auf die Oberseite des Kunststoffs (2) aufgetragen ist.

11. Solarmodul nach einem der Ansprüche 1 bis 10, dadurch gekennzeichnet, dass das flächenförmige, steife Element (6) aus Metall, Kunststoff oder Verbundwerkstoff besteht.

12. Solarmodul nach Anspruch 1, dadurch gekennzeichnet, dass die Solarzelle (7) auf das flächenförmige, steife Element (6) kaschiert ist.

13. Solarmodul nach einem der Ansprüche 1 bis 12, dadurch gekennzeichnet, dass im Bereich oberhalb der Solarzelle (7) eine Dünnglasschicht (10) aufgebracht ist.

14. Solarmodul nach einem der Ansprüche 1 bis 13, dadurch gekennzeichnet, dass der Kunststoff (2) ein duroplastischer Formstoff ist.

15. Solarmodul nach einem der Ansprüche 1 bis 14, dadurch gekennzeichnet, dass der Kunststoff (2) ein Epoxidharzformstoff ist.

16. Solarmodul nach einem der Ansprüche 1 bis 14, dadurch gekennzeichnet, dass der Kunststoff (2) ein Polyurethanharzformstoff ist.

17. Solarmodul nach einem der Ansprüche 1 bis 14, dadurch gekennzeichnet, dass der Kunststoff (2) ein Silikonharzformstoff ist.

18. Solarmodul nach einem der Ansprüche 1 bis 14, dadurch gekennzeichnet, dass der Kunststoff (2) ein Polyesterharzformstoff ist.

19. Solarmodul nach einem der Ansprüche 1 bis 14, dadurch gekennzeichnet, dass der Kunststoff (2) ein Acrylharzformstoff ist.

20. Solarmodul nach einem der Ansprüche 1 bis 14, dadurch gekennzeichnet, dass der duroplastische Kunststoff im Giess-, Imprägnier-, Laminier- oder Beschichtungsverfahren erzeugt wird.

21. Solarmodul nach einem der Ansprüche 1 bis 13, dadurch gekennzeichnet, dass der Kunststoff (2) ein Thermoplast ist.

22. Solarmodul nach einem der Ansprüche 1 bis 13, dadurch gekennzeichnet, dass der Kunststoff aus thermisch verschweissbaren Folien besteht.

**Claims**

1. A solar module, in which at least one solar cell (7) is embedded in synthetic resin (2) and is mechanically permanently connected to a carrier (5), characterised in that the carrier (5) is formed so as to be flexible; and that each solar cell (7) to protect it from damage, in particular breaking, is reinforced with an additional, flat rigid element (6) which is also mechanically permanently connected to the associated solar cell embedded in synthetic resin.

2. A solar module as claimed in claim 1, characterised in that the flat rigid element (6) occupies approximately the same area as the solar cell (7), and thus, together with the solar cell, partially fills the solar module.

3. A solar module as claimed in claim 1 and 2, characterised in that the flat rigid element (6) is connected to the synthetic resin (2) which encases the solar cell (7).

4. A solar module as claimed in one of claims 1 to 3, characterised in that the carrier (5) is a galvanised iron wire fabric, or galvanised iron wire netting.

5. A solar module as claimed in one of claims 1 to 3, characterised in that the carrier (5) is made of iron wire fabric or netting coated with a lacquer layer.

6. A solar module as claimed in one of claims 1 to 5, characterised in that a multi-layer foil (4) which serves as a vapour-diffusion barrier, is arranged between the synthetic resin (2) and the carrier (5).

7. A solar module as claimed in one of claims 1 to 6, characterised in that a glass fabric (8) is embedded in the synthetic resin (2).

8. A solar module as claimed in claim 7, characterised in that the glass fabric (8) is arranged in two layers, one above, and one below the solar cell (7).

9. A solar module as claimed in one of claims 1 to 8, characterised in that the electrical connection (3) of the solar cell is embedded in the synthetic resin (2).

10. A solar module as claimed in one of claims 1 to 9, characterised in that a light-permeable layer (1) of synthetic resin is applied to the top surface of the synthetic resin (2).

11. A solar module as claimed in one of claims 1 to 10, characterised in that the flat rigid element (6) consists of metal, synthetic resin or a compound material.

12. A solar module as claimed in claim 1, characterised in that the solar cell (11) is laminated to the flat rigid element (6).

13. A solar module as claimed in one of claims 1 to 12, characterised in that a thin glass layer (10) is applied in the region above the solar cell (7).

14. A solar module as claimed in one of claims 1 to 13, characterised in that the synthetic resin (2) is a thermoplastic moulded material.

15. A solar module as claimed in one of claims 1 to 14, characterised in that the synthetic resin (2) is an epoxy resin moulded material.

16. A solar module as claimed in one of claims 1 to 14, characterised in that the synthetic resin (2) is a polyurethane resin moulded material.

17. A solar module as claimed in one of claims 1 to 14, characterised in that the synthetic resin (2) is a silicone resin moulded material.

18. A solar module as claimed in one of claims 1 to 14, characterised in that the synthetic resin (2) is a polyester resin moulded material.

19. A solar module as claimed in one of claims 1 to 14, characterised in that the synthetic resin (2) is an acrylic resin moulded material.

20. A solar module as claimed in one of claims 1 to 14, characterised in that the thermoplastic synthetic resin is produced by a casting, impregnation, lamination or coating process.

21. A solar module as claimed in one of claims 1 to 13, characterised in that the synthetic resin (2) is a thermoplastic material.

22. A solar module as claimed in one of claims 1 to 13, characterised in that the synthetic resin consists of thermally weldable films.

**Revendications**

1. Module solaire, dans lequel au moins une pile solaire (7) est noyée dans une matière plastique (2) et est reliée rigidement, du point de vue mécanique, à un organe de support (5), caractérisé en ce que l'organe de support (5) est flexible et que chaque pile solaire (7) est renforcée, en vue de sa protection vis-à-vis d'un endommagement, notamment d'une rupture, par un élément supplémentaire rigide (6) de surface étendue, qui est également relié rigidement, du point de vue mécanique, à la pile solaire associée, noyée dans la matière plastique.

2. Module solaire suivant la revendication 1, caractérisé par le fait que l'élément rigide (6) de surface étendue occupe approximativement la même surface que la pile solaire (7), c'est-à-dire qu'en association avec la pile solaire, elle remplit par conséquent partiellement le module solaire.

3. Module solaire suivant les revendications 1 et 2, caractérisé par le fait que l'élément rigide (6) de surface étendue est relié à la matière plastique (2) enveloppant la pile solaire (7).

4. Module solaire suivant l'une des revendications 1 à 3, caractérisé par le fait que l'élément de support (5) est un tissu formé d'un fil de fer étamé ou est un filet formé d'un fil de fer étamé.

5. Module solaire suivant l'une des revendications 1 à 3, caractérisé par le fait que l'organe de support (5) formé d'un tissu ou d'un filet en fil de fer est recouvert par une couche de laque.

6. Module solaire suivant l'une des revendications 1 à 5, caractérisé par le fait qu'une feuille à couches multiples (4) utilisée comme dispositif de blocage contre la diffusion de la vapeur, est prévue entre la matière plastique (2) et l'organe de support (5).

7. Pile solaire suivant l'une des revendications 1 à 6, caractérisée par le fait qu'un tissu de verre (8) est noyé dans la matière plastique (2).

8. Pile solaire suivant la revendication 7, caractérisée par le fait que le tissu de verre (8) s'étend selon une couche respective au-dessus et au-dessous de la pile solaire (7).

9. Module solaire suivant l'une des revendications 1 à 8, caractérisé par le fait que la liaison électrique (3) des piles solaires est noyée dans la matière plastique (2).

10. Pile solaire suivant l'une des revendications 1 à 9, caractérisée par le fait qu'une couche de matière plastique transparente (1) est déposée sur la face supérieure de la matière plastique (2).

11. Module solaire suivant l'une des revendications 1 à 10, caractérisé par le fait que l'élément rigide (6) de surface étendue est constituée en un métal, une matière plastique ou un matériau composite.

12. Module solaire suivant la revendication 1, caractérisé par le fait que la pile solaire (7) est appliquée par doublage sur l'élément rigide (6) de surface étendue.

13. Module solaire suivant l'une des revendications 1 à 12, caractérisé par le fait qu'une couche de verre mince (10) est déposée dans la zone située au-dessus de la pile solaire (7).

14. Module solaire suivant l'une des revendications 1 à 13, caractérisé par le fait que la matière plastique (2) est une matière moulable thermodurcissable.

15. Module solaire suivant l'une des revendications 1 à 14, caractérisé par le fait que la matière plastique (2) est une matière moulable formée d'une résine époxy.

16. Module solaire suivant l'une des revendications 1 à 14, caractérisé par le fait que la matière plastique (2) est une matière moulable formée d'une résine de polyuréthane.

17. Module solaire suivant l'une des revendications 1 à 14, caractérisé par le fait que la matière plastique (2) est une matière moulable formée d'une résine au silicone.

18. Module solaire suivant l'une des revendications 1 à 14, caractérisé par le fait que la matière plastique (2) est une matière moulable formée d'une résine de polyester.

19. Module solaire suivant l'une des revendications 1 à 14, caractérisé par le fait que la matière plastique (2) est une matière moulable formée d'une résine acrylique.

20. Module solaire suivant l'une des revendications 1 à 14, caractérisé par le fait que la matière thermodurcissable est produite selon le procédé de coulée d'imprégnation, de stratification, ou d'enduction.

21. Module solaire suivant l'une des revendications 1 à 13, caractérisé par le fait que la matière plastique (2) est une matière thermoplastique.

22. Module solaire suivant l'une des revendications 1 à 13, caractérisé par le fait que la matière plastique est constituée par des feuilles soudables par action de la chaleur.

FIG 1

FIG 2

FIG 3

FIG 4

FIG 5